# EUROPÄISCHE PATENTSCHRIFT

(11) **EP 2 491 352 B1**
(45) Veröffentlichungstag und Bekanntmachung des Hinweises auf die Patenterteilung: **29.11.2017**
(21) Anmeldenummer: 10770530.3
(22) Anmeldetag: 19.10.2010
(51) Int. Cl.: G01D 5/241, H01H 1/00, H03K 17/96, H01H 19/00, H03K 17/975

(54) **DREHSTELLER**
ROTARY ACTUATOR
ACTIONNEUR ROTATIF

(30) Priorität: 21.10.2009 DE 102009050052
(43) Veröffentlichungstag der Anmeldung: 29.08.2012
(73) Patentinhaber: Leopold Kostal GmbH & Co. KG, 58513 Lüdenscheid (DE)
(72) Erfinder: BLECKMANN, Michael, 58239 Schwerte-Ergste (DE); BORGMANN, Uwe, 45665 Recklinghausen (DE)
(86) Internationale Anmeldenummer: PCT/EP2010/065740
(87) Internationale Veröffentlichungsnummer: WO 2011/048109

(56) Entgegenhaltungen:
- EP-A1- 1 870 267
- EP-A1- 2 246 771
- DE-A1- 4 442 044
- DE-A1- 10 065 447
- US-A- 4 584 626
- US-A- 5 315 865

## Beschreibung

Die Erfindung betrifft einen Drehsteller mit einem stationären Teil (Stator), an welchem eine kapazitive Sensorfläche angeordnet ist, und mit einem gegen das stationäre Teil drehbeweglichen Teil (Rotor), welches eine berührungsempfindliche Bedienfläche für die kapazitive Sensorfläche ausbildet.

Drehsteller mit integrierter kapazitiver Sensorik sind grundsätzlich bekannt. So beschreibt die DE 10 2004 010 406 B3 ein Informations- und Unterhaltungssystem, welches einen Drehsteller aufweist, in den eine berührungsempfindliche Fläche integriert ist. Die berührungsempfindliche Fläche kann dabei insbesondere als ein Touchscreen ausgeführt und als Eingabevorrichtung für eine Handschrifterkennung vorgesehen sein. Das Dokument offenbart dabei allerdings keine Details zum konstruktiven Aufbau des Touchscreens und des Drehstellers. Das Dokument EP2246771 A1 offenbart einen Drehsteller gemäß dem Stand der Technik. Zur Ausbildung einer berührungsempfindlichen Fläche an einem Drehsteller ist es zweckmäßig, die elektrischen Komponenten am stationären Teil anzuordnen, insbesondere damit die elektrischen Anschlüsse dieser Komponenten nicht die Drehbeweglichkeit des Rotors einschränken. Die eigentliche Bedienfläche kann durch die äußere Oberfläche des Rotors verwirklicht sein, von wo aus Berührungen auf die elektrischen Komponenten der Sensorfläche am Stator einwirken.

Bei einer feststehenden Sensorfläche unter einer drehbaren Bedienfläche ist zur Minimierung von störenden Reibeinflüssen ein Abstand zwischen einer inneren Fläche des Rotors und der Sensorfläche erforderlich, woraus sich ein Luftspalt zur Sensorfläche hin ergibt.

Die Eigenschaften berührungsempfindlicher kapazitiver Sensoren sind in starkem Maße abhängig von der Materialanordnung zwischen der Bedienfläche, auf die beispielsweise ein menschlicher Finger einwirken kann, und der eigentlichen Sensorfläche. Entscheidend für eine präzise Signalauswertung ist die materialspezifische relative Permittivität *ε*ᵣ und die Materialdicke. Hierbei besteht ein großer Unterschied der relativen Permittivität von Luft (*ε*ᵣ = 1,0) und von thermoplastischen Kunststoffen (*ε*ᵣ = 2,5 - 3,5), aus denen die Drehstellerkomponenten, wie beispielsweise der Rotor, vorzugsweise gefertigt sind. Durch diese Eigenschaft beeinflusst die Breite eines vorhandenen Luftspalts zwischen dem Rotor und der Sensorfläche überproportional die erfassten Kapazitätswerte.

Es besteht die Schwierigkeit, dass die relative Lage und der Abstand zwischen Bedienfläche und Sensorfläche bei einer Verdrehung des Rotors nicht genau eingehalten werden kann. Je nach Genauigkeit der Drehlagerung des Rotors können verschiedene Stellen der Bedienfläche unterschiedliche Abstände zur Sensorfläche aufweisen, welche sich zudem bei einer Drehung des Rotors noch verändern. Dadurch sind die elektrischen Eigenschaften des kapazitiven Sensors erheblich von der Betätigungsstelle abhängig und darüber hinaus auch bei Drehbetätigungen nicht konstant.

Es stellte sich die Aufgabe, einen Drehsteller zu schaffen, bei dem Sensorfehler durch variierende Abstände zwischen einer rotierenden Bedienfläche und einer feststehenden kapazitiven Sensorfläche weitgehend eliminiert sind.

Diese Aufgabe wird erfindungsgemäß dadurch gelöst, dass zwischen der berührungsempfindliche Bedienfläche und der Sensorfläche mindestens ein abstandsfixierendes Mittel angeordnet ist, und dass ein Federelement die Sensorfläche in Richtung der Bedienfläche drückt.

Bevorzugt ist das abstandsfixierende Mittel als eine drehfest gelagerte Gleitscheibe ausführbar, welche den Zwischenraum zwischen der Bedienfläche und der Sensorfläche nahezu vollständig ausfüllt. Das Material und die Oberflächenausbildung der Gleitscheibe ist so gewählt, dass sich die Unterseite des Rotors möglichst reibungsarm auf der Gleitscheibe entlang bewegt und dass zudem die Gleitscheibe eine an das Rotor- und Statormaterial möglichst gut angepasste Permittivität aufweist.

Alternativ zur Gleitscheibe können an der Sensorfläche oder an der Bedienfläche auch angeformte Stifte oder Erhebungen vorgesehen sein, die als Abstandshalter mit der Bedienfläche oder der Sensorfläche zusammenwirken. Die Abstandshalter erfüllen ebenfalls den Zweck, einen konstanten und möglichst geringen Abstand zwischen dem Stator- und dem Rotorteil vorzugeben. Die auftretenden Reibungskräfte können durch eine geeignete Oberflächenausbildung der Abstandshalter gering gehalten werden.

In jedem Fall ist ein Federelement vorgesehen, welches die Sensorfläche in Richtung des Rotors drückt, so dass das oder die abstandsfixierende(n) Mittel zwischen der Sensorfläche und der Unterseite des Rotors dicht eingeschlossen werden.

Besonders vorteilhaft ist es, wenn das Federelement Bestandteil eines elektrischen Schalters ist. Eine solche Anordnung ermöglicht neben dem Ausgleich von Taumelbewegungen des Rotors zugleich die Ausbildung einer Druckschalterfunktion des Drehstellers unter Beibehaltung eines konstanten Luftspalts.

Ausführungsbeispiele der Erfindung sind in der Zeichnung dargestellt und werden im folgenden anhand der Zeichnung näher erläutert. Es zeigen
- Figur 1: eine schematische Schnittansicht eines Drehstellers,
- Figur 2: eine schematische Schnittansicht eines weiteren Drehstellers,
- Figur 3: die Schnittansicht einer realen Ausführung eines Drehstellers.

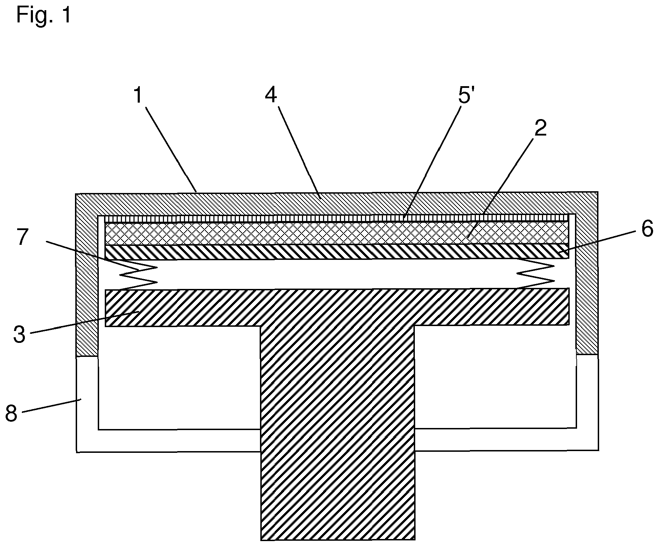

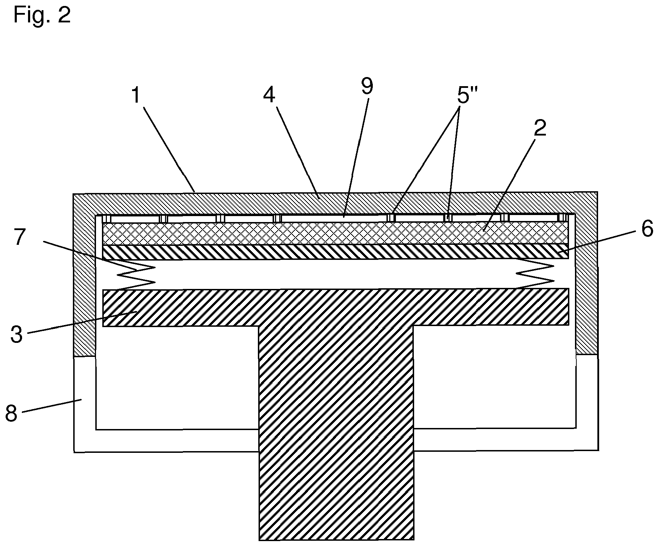

Die Figuren 1 und 2 zeigen jeweils den schematischen Aufbau eines erfindungsgemäßen Drehstellers in einer Schnittdarstellung. Der Drehsteller besteht aus einem feststehend angeordneten, stempelförmig ausgebildeten Stator 3, um den herum ein Rotor 4 angeordnet ist. Der Rotor 4 ist als ein hohlzylinderartiges Drehrad ausgeführt, das an feststehenden Gehäuseteilen 8 des Drehstellers drehbar gelagert ist.

Mit dem Stator 3 ist über Federelemente 7 eine Stützplatte 6 verbunden, die eine Sensorfläche 2 trägt. Die hier nur schematisch dargestellte Sensorfläche 2 ist vorzugsweise durch eine flächig ausgedehnte Leiterstruktur gebildet, die mit einer nicht dargestellten Verarbeitungselektronik elektrisch verbunden ist. Die Leiterstruktur bildet ein Kondensatorsystem aus, welches durch Kapazitätsänderungen die Annäherung von Gegenständen an eine Bedienfläche 1, welche durch die Oberfläche des Rotors 4 ausgebildet ist, ortsauflösend auswerten kann.

Um zu erreichen, dass der Rotor 4 gegen die Sensorfläche 2 ohne störende Reibung drehbar ist, ist die Sensorfläche 2 mit einem Abstand zur Unterseite des Rotors 4 angeordnet. Damit sich dieser Abstand möglichst wenig störend auf die Kapazitätsmessungen auswirken kann, ist es erforderlich, dass der Abstand erstens möglichst klein und zweitens über die gesamte Sensorfläche 2 möglichst konstant ist und sich drittens bei einer Drehung des Rotors 4 möglichst wenig ändert.

Um diese Bedingungen zu erfüllen, ist mindestens ein abstandsfixierendes Mittel (5', 5") vorgesehen, welches den Abstand zwischen der Sensorfläche 2 und dem Rotor 4 möglichst klein und konstant hält.

Die Figur 2 zeigt als abstandsfixierende Mittel mehrere an die Sensorfläche 2 oder an die Unterseite des Rotors 4 angeformte Abstandshalter 5". Die Abstandshalter 5" weisen die Form von Stiften oder von lokalen Erhebungen auf. Form und Oberfläche der Abstandshalter 5" sind so gestaltet, dass die beweglich anliegende Fläche, also die Unterseite des Rotors 4 bzw. die Sensorfläche 2, möglichst reibungsarm an den Abstandshaltern 5" entlang gleiten kann. Die vertikale Ausdehnung der Abstandshalter 5" ist in der Figur 2 maßstäblich stark übertrieben dargestellt, so dass der resultierende Luftspalt 9 in einer realen Anordnung sehr viel schmaler als hier dargestellt sein kann und damit nur einen geringen Einfluss auf die elektrischen Eigenschaften des Drehstellers hat. Besonders vorteilhaft ist, dass der Luftspalt 9 nicht nur sehr schmal ist, sondern auch bei Betätigung des Drehstellers, also einer Drehung des Rotors 4 gegen den Stator 3, mit großer Genauigkeit konstant bleibt, da durch die Anpresskraft der Federelemente 7 die Sensorfläche 2 stets dicht an den Abstandshaltern 5" anliegt.

Figur 1 zeigt als abstandsfixierendes Mittel eine Gleitscheibe 5' zwischen der Sensorfläche 2 und der Unterseite des Rotors 4. Die Gleitscheibe 5' ist vorzugsweise als eine biegeweiche Kunststoffscheibe oder Kunststofffolie mit einer möglichst glatten und reibungsarmen Oberfläche ausgeführt, die gegebenenfalls zusätzlich mit einem Schmierstoff beschichtet sein kann.
Die Gleitscheibe 5' füllt vorzugsweise den gesamten Zwischenraum zwischen der Sensorfläche 2 und der Unterseite des Rotors 4 aus, so dass die Breite des Luftspalts zwischen der Gleitscheibe 5' und der Sensorfläche 2 bzw. der Unterseite des Rotors 4 vernachlässigbar wird. Die Permittivität des Materials der Gleitscheibe 5' hat einen ähnlichen Wert, wie das Material, aus dem der Rotor 4 besteht. Die Gleitscheibe 5' ist vorzugsweise nur wenig kompressibel, so dass sie durch gegebenenfalls auftretende Taumelbewegungen des Rotors 4 relativ zum Stator 3 nicht nennenswert zusammengepresst wird.

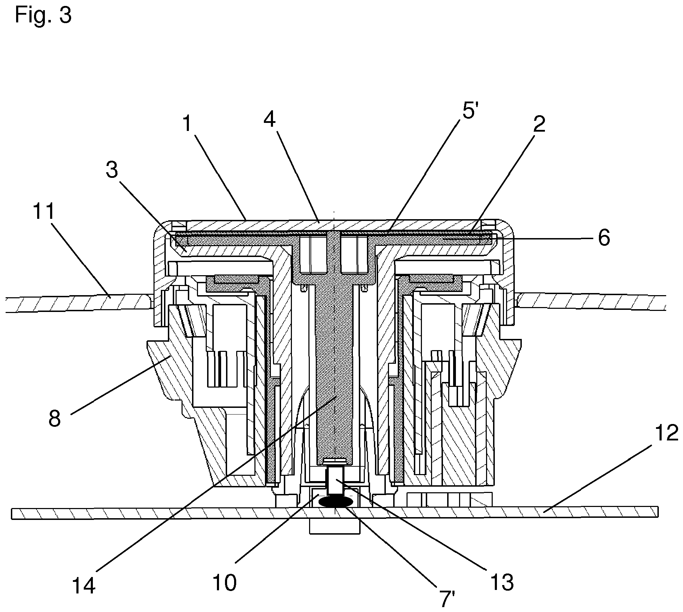

Figur 3 zeigt eine Schnittansicht einer realen Ausgestaltung eines Drehstellers. Der Drehsteller ist innerhalb einer Bedienblende 11 angeordnet und steht mit seiner Unterseite auf einer Grundfläche 12 auf, die vorzugsweise durch eine Leiterplatte gebildet ist. Mit der Leiterplatte ist ein Druckschalter 10 elektrisch verbunden, dessen Schaltstößel 13 gegen die Rückstellkraft eines Federelements 7' betätigbar ist.

An dem Schaltstößel 13 liegt ein stempelförmiger Abschnitt 14 des Stators 3 des Drehstellers an. Über den stempelförmigen Abschnitt 14 und den Schaltstößel 13 wirkt die Kraft des Federelements 7' auf den Stator 3 und presst eine horizontal ausgerichtete Stützplatte 6 gegen die Gleitscheibe 5' welche dadurch wiederum dicht an der Unterseite des kappenförmigen Rotors 4 anliegt. Die Kraft des Federelements 7' bewirkt, dass bei einer Drehbetätigung des Rotors 4 nahezu kein Zwischenraum zwischen dem die elektrische Sensorik tragenden Stator 3 und dem Rotor 4 entsteht. Hierdurch sind die elektrischen Eigenschaften bei einer Berührung der Bedienfläche 1 nahezu unabhängig von der jeweiligen Betätigungsstelle, und ändern sich auch bei einer Verdrehung des Rotors 4 nicht.

Durch den Druckschalter 10 wird eine Druckschaltfunktion geschaffen, die durch eine Druckbetätigung auf die Bedienfläche 1 ausgelöst werden kann. Die Druckbetätigung kann beispielsweise zur bestätigenden Auslösung einer zuvor durch Berührung der Bedienfläche 1 ausgewählten Schaltfunktion vorgesehen sein. Da sich auch bei einer Druckbetätigung die Abstände zwischen Stator 3 und Rotor 4 nicht ändern, hat auch die Druckschaltfunktion keinerlei negativen Einfluss auf die Qualität der kapazitiven Sensorik.

### Bezugszeichen

- 1: Bedienfläche
- 2: Sensorfläche
- 3: Stator
- 4: Rotor
- (5', 5"): abstandsfixierende Mittel
- 5': Gleitscheibe
- 5": Stifte (Abstandshalter)
- 6: Stützplatte
- 7, 7': Federelement(e)
- 8: feststehende Gehäuseteile
- 9: Luftspalt
- 10: (Druck-)Schalter
- 11: Bedienblende
- 12: Grundfläche (Leiterplatte)
- 13: Schaltstößel
- 14: stempelförmiger Abschnitt

## Patentansprüche

1. Drehsteller
mit einem stationären Teil (Stator), an welchem eine kapazitive Sensorfläche angeordnet ist,
und mit einem gegen das stationäre Teil drehbeweglichen Teil (Rotor), welches eine berührungsempfindliche Bedienfläche für die kapazitive Sensorfläche ausbildet, wobei zwischen der berührungsempfindliche Bedienfläche (1) und der Sensorfläche (2) mindestens ein abstandsfixierendes Mittel (5', 5") angeordnet ist,
**dadurch gekennzeichnet, dass** ein Federelement (7, 7') die Sensorfläche (2) in Richtung der Bedienfläche (1) drückt.

2. Drehsteller nach Anspruch 1, **dadurch gekennzeichnet, dass** das abstandsfixierende Mittel durch eine Gleitscheibe (5') ausgebildet ist.

3. Drehsteller nach Anspruch 1, **dadurch gekennzeichnet, dass** das/die abstandsfixierende Mittel durch an die Sensorfläche (2) oder an die Bedienfläche (1) angeformte Abstandshalter (5") ausgebildet ist/sind.

4. Drehsteller nach Anspruch 1, **dadurch gekennzeichnet, dass** das/die abstandsfixierende Mittel am Stator (3) angeordnet ist/sind.

5. Drehsteller nach Anspruch 1, **dadurch gekennzeichnet, dass** der Rotor (4) durch eine Druckbetätigung gegen den Stator (3) verschiebbar ist und durch die Verschiebung einen Schalter (10) betätigt.

6. Drehsteller nach Anspruch 5, **dadurch gekennzeichnet, dass** das Federelement (7') Bestandteil des Schalters (10) ist.

## Claims

1. Rotary actuator
having a stationary constituent (stator) on which a capacitive sensor surface is located,
and having a constituent (rotor) which rotates against the stationary constituent and forms a touch-sensitive operating surface for the capacitive sensor surface,
whereby at least one gap-establishing expedient (5', 5") is located between the touch-sensitive operating surface (1) and the sensor surface (2),
**characterised in that**
a spring element (7, 7') presses the sensor surface (2) in the direction of the operating surface (1).

2. Rotary actuator according to Claim 1, **characterised in that** the gap-establishing expedient is formed by a sliding disc (5').

3. Rotary actuator according to Claim 1, **characterised in that** the gap-establishing expedient is formed by a spacer or spacers (5") moulded onto the sensor surface (2) or onto the operating surface (1).

4. Rotary actuator according to Claim 1, **characterised in that** the gap-establishing expedient is located on the stator (3).

5. Rotary actuator according to Claim 1, **characterised in that** the rotor (4) can be moved against the stator (3) by means of pressure actuation, operating a switch (10) as a result of this movement.

6. Rotary actuator according to Claim 5, **characterised in that** the spring element (7') is a constituent of the switch (10).

## Revendications

1. Actionneur rotatif,
avec une partie stationnaire (stator), sur laquelle est disposée une surface de détection capacitive,
et avec une partie mobile (rotor) en rotation par rapport à la partie stationnaire, laquelle forme une surface de commande tactile pour la surface de détection capacitive,
sachant
qu'un moyen de fixation à distance (5', 5") est disposé entre la surface de commande tactile (1) et la surface de détection (2),
**caractérisé en ce**
**qu'**un élément élastique (7, 7') presse la surface de détection (2) dans la direction de la surface de commande (1).

2. Actionneur rotatif selon la revendication 1, **caractérisé en ce que** le moyen de fixation à distance est formé par une plaque coulissante (5').

3. Actionneur rotatif selon la revendication 1, **caractérisé en ce que** le / les moyen/s de fixation à distance est / sont formé/s par des écarteurs (5") qui sont formés sur la surface de détection (2), ou sur la surface de commande (1)

4. Actionneur rotatif selon la revendication 1, **caractérisé en ce que** le / les moyen/s de fixation à distance est / sont disposés sur le stator (3).

5. Actionneur rotatif selon la revendication 1, **caractérisé en ce que** le rotor (4) peut être déplacé par pression contre le stator (3) et qu'un commutateur (10) est actionné par le déplacement.

6. Actionneur rotatif selon la revendication 5, **caractérisé en ce que** l'élément élastique (7') est partie constituante du commutateur (10).
